# EUROPÄISCHE PATENTANMELDUNG

(11) **EP 4 815 309 A1**
(43) Veröffentlichungstag der Anmeldung: **30.09.2026**
(21) Anmeldenummer: 26167526.8
(22) Anmeldetag: 25.03.2026
(51) Int. Cl.: H03K 17/95

(54) **NÄHERUNGSSENSOR MIT ZUMINDEST EINER SENDESPULE UND EINER AUSGLEICHSSPULE SOWIE VERFAHREN ZUM BETREIBEN EINES NÄHERUNGSSENSORS**

(30) Priorität: 28.03.2025 DE 102025112284
(71) Anmelder: Turck Holding GmbH, 58553 Halver (DE)
(72) Erfinder: Riese, Thomas, 42653 Solingen (DE)
(74) Vertreter: DTS Patent- und Rechtsanwälte PartmbB

(57) **Zusammenfassung**

Die vorliegende Erfindung betrifft einen Näherungssensor (10) mit zumindest einer Sendespule (12) und einer Ausgleichsspule (14); wobei die Ausgleichsspule (14) von der Sendespule getrennt ausgebildet ist und zumindest teilweise um die Sendespule (12) herum umlaufend, insbesondere im Wesentlichen vollständig um die Sendespule (12) herum umlaufend, ausgebildet ist; und wobei die Ausgleichsspule (14) mit einer Verstärkerschaltung (20) verbunden ist; wobei die Verstärkerschaltung (20) dazu eingerichtet ist, an einem Eingang eine in der Ausgleichsspule (14) induzierte elektrische Spannung aufzunehmen und an einem Ausgang einen Ausgleichsstrom so auszugeben, dass die induzierte elektrische Spannung kompensiert wird. Die Erfindung betrifft ferner ein Verfahren zum Betreiben eines Näherungssensors (10).

## Beschreibung

Die vorliegende Erfindung betrifft einen Näherungssensor mit zumindest einer Sendespule und einer Ausgleichsspule sowie ein Verfahren zum Herstellen eines Näherungssensors. Sie betrifft ferner ein Verfahren zum Betreiben eines Näherungssensors.

Näherungssensoren beziehungsweise Näherungsschalter werden in verschiedenen Anwendungen eingesetzt, beispielsweise in der Industrieautomatisierung. Typischerweise sind Näherungsschalter dazu eingerichtet, ein metallisches Zielobjekt, beispielsweise eine sogenanntes "Schaltblech", zu detektieren und in Abhängigkeit von der Anwesenheit des Zielobjekts in einem Erfassungsbereich des Näherungsschalters beziehungsweise beim Über- oder Unterschreiten eines bestimmten Abstands ein Schaltsignal auszulösen. Hierzu ist zum Beispiel ein Schaltabstand definiert und das Schaltsignal wird ausgelöst, wenn der Schaltabstand unterschritten wird.

Derartige Näherungssensoren können anhand verschiedener Funktionsprinzipien konstruiert werden. Typischerweise wird ausgenutzt, dass ein elektromagnetisches Feld durch die Anwesenheit und Position des metallischen Zielobjekts beeinflusst wird. Die Messung eines Parameters eines elektromagnetischen Feldes erlaubt daher Aussagen über das Zielobjekt, insbesondere über seine Position und Lage in einer Umgebung des Näherungssensors.

Näherungssensoren werden häufig auch in einer metallischen Umgebung eingesetzt. Um Störungen durch das metallische Material in der unmittelbaren Umgebung des Näherungssensors zu vermeiden, kann der Näherungssensor aus dieser Umgebung hervorstehend angeordnet werden; man spricht von einem "nicht-bündigen" Einbau, bei dem beispielsweise eine Sende- oder Empfangsspule beziehungsweise alle Spulen des Näherungssensors nicht von Metall umgeben sind.

In anderen Szenarien wäre ein hervorstehender Näherungssensor hingegen nachteilig und er soll daher bündig mit einem umgebenden metallischen Material abschließen oder tiefer in die metallische Umgebung versenkt eingebaut werden. Dies führt typischerweise zu Störungen durch das umgebende Metall, was sich beispielsweise in einem veränderten Schaltabstand oder einer weniger genauen Detektion äußert. Eine solche metallische Umgebung kann eine Halterung aus Metall sein, in welche der Näherungssensor eingeschraubt oder eingesetzt wird.

Der störende Einfluss einer metallischen Umgebung ist dabei nicht unbedingt so stark, dass der Sensor dadurch betätigt wird. Vielmehr kann der Sensor auch nur teilweise beeinflusst werden. Dadurch kann sich beispielsweise der Schaltabstand auf das eigentliche Betätigungsblech verändern. In der Regel wird der Schaltabstand durch die metallische Umgebung größer, sodass das eigentliche Zielobjekt bereits in einem größeren Abstand erkannt und das Schaltsignal somit vorzeitig ausgelöst wird. Dies kann zu Abweichungen vom erwarteten Verhalten es Näherungssensors führen.

Es ist beispielsweise bekannt, Abschirmbleche zu verwenden, um die genannten Störungen zu vermindern. Dies erschwert allerdings die Montage bei der Herstellung eines solchen Näherungssensors.

In den Druckschriften DE 10 2021 121 886 A1, DE 103 50 733 B4, DE 10 2006 053 023 B4 und DE 10 2010 042 815 A1 werden induktive Näherungsschalter beschrieben. Auch aus der Druckschrift DE 101 64 302 A1 ist eine Detektorvorrichtung bekannt. Den bekannten Vorrichtungen ist gemeinsam, dass der bündige Einbau des Näherungssensors in einer metallischen Umgebung zu Störungen und einer verschlechterten Detektionsleistung führt.

Es ist daher die Aufgabe der vorliegenden Erfindung, einen Näherungssensor, ein Verfahren zu seiner Herstellung und ein Verfahren zu seinem Betrieb bereitzustellen, bei denen auch bei bündiger Positionierung des Näherungssensors in einer metallischen Umgebung eine genaue und zuverlässige Detektion erfolgen kann.

Diese Aufgabe wird erfindungsgemäß gelöst durch einen Näherungssensor mit den Merkmalen des Anspruchs 1 sowie durch ein Verfahren mit den Merkmalen des unabhängigen Verfahrensanspruchs 9 beziehungsweise ein Verfahren mit den Merkmalen des unabhängigen Verfahrensanspruchs 10. Vorteilhafte Ausgestaltungen sind in den Unteransprüchen angegeben.

Danach wird die Aufgabe gelöst durch einen Näherungssensor mit zumindest einer Sendespule und einer Ausgleichsspule, insbesondere einer Ausgleichswicklung, wobei die Ausgleichsspule von der Sendespule getrennt und zumindest teilweise um die Sendespule herum umlaufend ausgebildet ist. Insbesondere kann die Ausgleichsspule im Wesentlichen vollständig um die Sendespule herum umlaufend ausgebildet sein.

Insbesondere ist die getrennte Ausbildung der Ausgleichsspule und der Sendespule so zu verstehen, dass diese nicht direkt miteinander gekoppelt sind. Insbesondere gibt es keine leitende Verbindung direkt zwischen der Ausgleichsspule und der Sendespule. Insbesondere sind die Ausgleichsspule und die Sendespule transformatorisch miteinander gekoppelt, sodass durch das elektromagnetische Feld der Sendespule eine Spannung in der Ausgleichsspule induzierbar ist.

Insbesondere umfasst die Ausgleichsspule wenigstens eine Ausgleichswicklung, sie kann also aus mindestens einer umlaufenden Windung bestehen.

Ferner ist die Ausgleichsspule mit einer Verstärkerschaltung verbunden und die Verstärkerschaltung ist dazu eingerichtet, an einem Eingang eine in der Ausgleichsspule induzierte elektrische Spannung aufzunehmen und an einem Ausgang einen Ausgleichsstrom so auszugeben, dass die induzierte elektrische Spannung kompensiert wird.

Insbesondere kann vorgesehen sein, dass die Ausgleichsspule die Sendespule vollständig oder zu wenigstens 90% umschließt. Dabei bezieht sich das Umschließen der Sendespule auf ihren Umfang beziehungsweise auf ein Umschließen in radialer Richtung.

Insbesondere kann zumindest eine Windung der Ausgleichsspule so ausgebildet sein, dass sie die Sendespule vollständig umschließt, wobei ein Anfangspunkt und ein Endpunkt der Windung der Ausgleichsspule so angeordnet sind, dass in radialer Richtung der Sendespule ein Überlappungsbereich besteht; die zwischen Anfangspunkt und Endpunkt ausgebildete Windung umschließt daher die Sendespule vollständig.

Die Ausgleichsspule kann mit der Sendespule in der gleichen Spulenebene angeordnet sein.

Die Ausgleichsspule kann bei anderen Beispielen in einer anderen Spulenebene als die Sendespule angeordnet sein. Diese weitere Spulenebene kann parallel zu einer Spulenebene der Sendespule angeordnet sein. Die parallelen Spulenebenen der Sendespule und der Ausgleichsspule sind zum Beispiel höchstens 10 % des maximalen Durchmessers der Sendespule voneinander entfernt, bevorzugt höchstens 5 %, weiter bevorzugt höchstens 2 %. [

Die Ausgleichsspule kann beispielsweise "umlaufend" um die Sendespule herum in dem Sinne gebildet sein, dass die Sendespule bei einer Draufsicht auf den Näherungssensor innerhalb der Ausgleichsspule angeordnet ist. Beispielsweise können die Ausgleichsspule und die Sendespule um die gleiche Längs- oder Rotationsachse angeordnet sein, wobei der Radius der Ausgleichsspule überall größer ist als der Radius der Sendespule.

Insbesondere ist die Verstärkerschaltung dazu eingerichtet, die Ausgleichsspule mit dem Ausgleichsstrom zu beaufschlagen. Bei einer weiteren Ausbildung kann eine zusätzliche Ausgleichsspule mit dem Ausgleichsstrom beaufschlagt werden, sodass das Streufeld von der einen Ausgleichsspule sensiert und durch die zusätzliche Ausgleichsspule kompensiert wird.

Der Ausgleichsstrom kann so gebildet sein, dass die induzierte elektrische Spannung in der Ausgleichsspule vollständig oder teilweise kompensiert oder gar überkompensiert wird.

Insbesondere wird dabei die Ausgleichsspule mit dem erzeugten Ausgleichsstrom beaufschlagt und es wird ein Wechselfeld erzeugt, durch den wiederum ein Magnetfeld erhalten wird, das einem Streufeld der Sendespule entgegengesetzt ist. Das auf die Ausgleichsspule wirkende elektromagnetische Feld wird dadurch ausgeglichen.

Insbesondere wird die elektrische Spannung in der Ausgleichsspule durch die Sendespule induziert.

Beim Betrieb des Näherungssensors wird die Sendespule mit einem Wechselstrom so beaufschlagt, dass ein zeitlich veränderliches elektromagnetische Feld entsteht. Durch dieses Feld beziehungsweise durch diejenigen Feldanteile, die sich in radialer Richtung über die von der Ausgleichsspule umschlossenen Fläche hinaus erstrecken, wird in der Ausgleichsspule eine Spannung induziert.

Die Ausgleichsspule ist also einem seitlichen Streufeld der Sendespule ausgesetzt und dieses seitliche Streufeld induziert eine Spannung in der Ausgleichsspule.

Das seitliche Streufeld wirkt zudem auf die metallische Umgebung ein, welche folglich die Funktionsweise des Sensors im Allgemeinen negativ beeinflusst. Solche Streufelder werden durch die Verstärkerschaltung weitgehend kompensiert, um damit die ungewollte Beeinflussung der Funktion des Näherungssensors zu verringern.

Mit anderen Worten sorgt eine Rückkopplung vom Ausgang des Verstärkers zu seinem invertierenden Eingang dazu, dass ein geschlossener Regelkreis entsteht, in dem der Verstärker an seinen Eingängen eine Differenzspannung von 0 V einregelt, was einer durch ein Feld erzeugten Induktionsspannung in der Ausgleichsspule von ebenfalls 0 V entspricht. Damit wird ein seitliches Streufeld der Sendespule kompensiert.

Es werden daher die seitlichen Streufelder vermindert, die bei einem bündigen Einbau des Näherungssensors beziehungsweise der Spulen des Näherungssensors mit einer metallischen Umgebung störend interagieren.

Der anspruchsgemäße Näherungssensor kann auf an sich bekannte Weise aufgebaut sein. Er kann beispielsweise die Sendespule als Teil eines Schwingkreises aufweisen, der ein Wechselfeld erzeugt. Wenn das Zielobjekt in den Erfassungsbereich eintritt, dann werden darin Wirbelströme induziert, sodass Energie aus dem elektromagnetischen Feld abfließt. Hierdurch verschlechtert sich die Güte des Schwingkreises und die Amplitude wird kleiner. Dadurch wird die Anwesenheit des metallischen Zielobjekts erkannt.

Insbesondere wird beim Unterschreiten eines Schwellenwerts der Amplitude ein Schaltsignal ausgelöst. Insbesondere genügt bei einem solchen Näherungssensor eine einzelne Sendespule und es kann auf eine Empfangsspule verzichtet werden.

Bei einem weiteren Beispiel umfasst der Näherungsschalter eine Sendespule und zumindest eine Empfangsspule. Hierbei wird eine Differenzspannung gemessen, die sich verändert, wenn ein Zielobjekt in den Erfassungsbereich eintritt oder wenn sich der Abstand des Zielobjekts zum Näherungssensor verändert. Das Schaltsignal kann dann in Abhängigkeit von der Differenzspannung ausgelöst werden.

Bei dem Näherungssensor wird der Ausgleichsstrom so gebildet, dass die in der Ausgleichsspule induzierte elektrische Spannung zu jeder Zeit weitgehend kompensiert wird. Das hat zur Folge, dass das durch die Ausgleichsspule erzeugte Feld dem von außen einwirkenden Feld, insbesondere dem Streufeld der Sendespule, entgegenwirkt. Es kommt zu einer destruktiven Interferenz und damit einer zumindest teilweisen Auslöschung beziehungsweise Kompensation, insbesondere in einem radial außen vom Näherungssensor angeordneten Streubereich.

Da somit das erzeugte elektromagnetische Feld im Bereich der Umgebung schwächer ist, insbesondere im Streubereich, werden auch die dadurch hervorgerufenen Störungen durch das umgebende Metall verringert.

Insbesondere induziert also bei dem Näherungssensor das elektromagnetische Feld der Sendespule eine Spannung in der Ausgleichsspule. Die Verstärkerschaltung erzeugt in Abhängigkeit von der induzierten Spannung einen zeitlich veränderlichen Strom, welcher der Ausgleichsspule aufgeprägt wird. Um die in der Ausgleichsspule induzierte Spannung auszugleichen, wirkt die Verstärkerschaltung insbesondere invertierend, beispielweise mit einem Verstärkungsfaktor von -1.

Anders als bei bekannten Lösungen ist bei dem anspruchsgemäßen Näherungsschalter die Ausgleichsspule nicht mit einer Sende- oder Empfangsspule gekoppelt. Vielmehr sind die Sendespule und die Ausgleichsspule getrennt voneinander ausgebildet. Elektromagnetische Felder wirken auf die Ausgleichsspule ein und die Verstärkerschaltung ist so gebildet, dass die Felder kompensiert werden.

Je nach dem Funktions- und Konstruktionsprinzip des Näherungsschalters werden daher die elektromagnetischen Felder beziehungsweise Streufelder einer oder mehrerer Spulen automatisch gleichzeitig und durch die gleiche Ausgleichsspule kompensiert.

Je nach dem Funktions- und Konstruktionsprinzip des Näherungsschalters kann eine oder mehrere Spulen vom durch dieselbe Ausgleichsspule kompensierten elektromagnetischen Felder durchflutet werden.

Bei einer Ausbildung weist der Näherungssensor ferner zumindest eine Empfangsspule auf. Insbesondere können mehrere Empfangsspulen vorgesehen sein.

Die Ausgleichsspule kann insbesondere genau eine Windung umfassen, insbesondere eine Ausgleichswicklung. Bei weiteren Ausbildungen kann die Ausgleichsspule mehrere Windungen aufweisen.

Es kann ein Feinabgleich der Stärke der Kompensation erfolgen. Die Zahl der Windungen der Ausgleichsspule kann insbesondere in Abhängigkeit vom Sensortyp gewählt werden. Dabei sind die räumliche Verteilung der Ausgleichsspule und die daraus resultierende Kopplung des Sensorfeldes mit nicht zwingend allen Windungen der Ausgleichsspule zu beachten. Bei einer Ausbildung kann eine Stapelung der Windungen auf mehreren Lagen einer Platine vorgesehen sein, insbesondere um eine Schraubenbahn zu erhalten statt einer spiralförmigen Ausbildung der Ausgleichsspule.

Bei einer weiteren Ausbildung sind die Sendespule und/oder die Ausgleichsspule als gedruckte Spulen ausgebildet.

Sie können insbesondere als Planarspulen ausgebildet sein.

Die Sendespule beziehungsweise Empfangsspule und die Ausgleichsspule sind dabei insbesondere als Luftspulen ausgebildet, sie weisen also keinen weichmagnetischen Kern auf.

Die Sendespule und die Ausgleichsspule beziehungsweise die Empfangsspule und die Ausgleichsspule können auf einer gemeinsamen Platine angeordnet sein.

Bei einer Weiterbildung ist die Sendespule mehrlagig in mehreren Schichten oder sogenannten "Kupferlagen" der Platine ausgebildet, wobei zumindest eine Windung der die Ausgleichsspule in zumindest einer gemeinsamen Schicht mit der Sendespule angeordnet ist.

Optional erstreckt sich auch die Ausbildung der Ausgleichsspule über mehrere Lagen, wobei beispielsweise eine einzelne Windung über mehrere Lagen verteilt sein kann oder wobei mehrere Windungen der Ausgleichsspule in mehreren Lagen vorgesehen sein können. In diesem Fall können alle oder zumindest eine der Windungen der Ausgleichsspule in einer Schicht angeordnet sein, in der auch die Sendespule angeordnet ist.

Bei einer Ausbildung ist die Ausgleichsspule auf einer Platine so angeordnet, dass sie möglichst dicht am Rand der Platine verläuft. Beispielsweise kann der Abstand des Materials der Ausgleichsspule vom Rand der Platine höchstens 10 %, bevorzugt höchstens 5 %, weiter bevorzugt höchstens 2 % eines Durchmessers beziehungsweise einer Quererstreckung der Platine betragen. Ferner kann eine Randmetallisierung einer Platine vorgesehen sein, sodass die Ausgleichsspule direkt am Rand der Platine verläuft.

Die Verstärkerschaltung kann insbesondere auf an sich bekannte Weise ausgebildet sein.

Sie kann in Abhängigkeit von äußeren Faktoren an den jeweiligen Einsatzbereich oder Kontext angepasst werden, etwa in Abhängigkeit von den Anforderungen an die elektromagnetische Verträglichkeit beim Betrieb der Schaltung.

Bei einer Ausbildung umfasst die Verstärkerschaltung einen invertierenden Verstärker, insbesondere einen Differenzverstärker oder Operationsverstärker.

Bei einer weiteren Ausbildung weist die Verstärkerschaltung einen Verstärkungsfaktor kleiner -0,9 auf, bevorzugt kleiner -1,0. Dadurch kann vorteilhafterweise ein seitliches Streufeld optimal kompensiert werden, auch bei Verlusten innerhalb der Verstärkerschaltung und der Ausgleichsspule.

Die Verstärkerschaltung kann ferner so ausgebildet sein, dass der Verstärkungsfaktor einstellbar ist, beispielweise durch eine Nutzereingabe oder ein Einstellen am Näherungssensor. Dadurch können die Detektionseigenschaften des Näherungssensors vorteilhafterweise angepasst werden, beispielsweise wenn der Näherungssensor ohne ein metallisches Umfeld verwendet wird.

Bei einer Weiterbildung sind die Sendespule und die Ausgleichsspule konzentrisch ausgebildet. Sie können ferner ein gemeinsames geometrisches Zentrum aufweisen, etwa wenn sie verschiedene geometrische Formen aufweisen.

Die Sendespule und/oder die Ausgleichsspule können in anderen Beispielen eine andere Form aufweisen als runde Spulen. Einzelne Wicklungen der Spulen können beispielsweise einer Kreis- oder Spiralform folgen oder oval ausgebildet sein. Sie können ferner quadratisch oder rechteckig ausgebildet sein, gegebenenfalls mit abgerundeten Ecken.

Ferner kann bei einer Ausbildung die Ausgleichsspule eine andere geometrische Form aufweisen als die Sendespule. Zum Beispiel kann die Ausgleichsspule so ausgebildet sein, dass sie möglichst dicht am Rand der Platine verläuft, wobei ihre Form der Form des Platinenrandes entspricht, während zugleich die Sendespule eine andere Form aufweist. So kann die Sendespule zum Beispiel rund oder spiralförmig ausgebildet sein, während die Ausgleichsspule am Rand der rechteckigen Platine verläuft und entsprechend geformt ist.

Bei dem Verfahren zum Herstellen eines Näherungssensors wird zumindest eine Sendespule bereitgestellt und es wird eine von der Sendespule galvanisch getrennte und zumindest teilweise, insbesondere im Wesentlichen vollständig, um die Sendespule herum umlaufende Ausgleichsspule so bereitgestellt, dass die Ausgleichsspule mit einer Verstärkerschaltung verbunden ist. Dabei ist die Verstärkerschaltung dazu eingerichtet, an einem Eingang der Verstärkerschaltung eine in der Ausgleichsspule induzierte elektrische Spannung aufzunehmen und an einem Ausgang einen Ausgleichsstrom so auszugeben, dass die induzierte elektrische Spannung kompensiert wird.

Die Verstärkerschaltung umfasst dabei beispielsweise einen invertierenden Verstärker, etwa einen Operationsverstärker.

Bei dem Verfahren zum Betreiben eines Näherungssensors mit einer Sendespule und einer von der Sendespule getrennt ausgebildeten und zumindest teilweise, insbesondere im Wesentlichen vollständig, um die Sendespule herum umlaufenden Ausgleichsspule, wobei die Ausgleichsspule mit einer Verstärkerschaltung verbunden ist, werden die folgenden Schritte ausgeführt:
- Aufnehmen einer in der Ausgleichsspule durch ein elektromagnetisches Feld, insbesondere ein Streufeld der Sendespule, induzierten elektrischen Spannung an einem Eingang der Verstärkerschaltung; und
- Ausgeben eines Ausgleichsstroms an einem Ausgang der Verstärkerschaltung so, dass das elektromagnetische Feld, insbesondere das Streufeld der Sendespule, kompensiert wird.

Die obigen Verfahren sind dazu ausgebildet, den vorliegend beschriebenen Näherungsschalter herzustellen beziehungsweise zu betreiben. Sie weisen daher die gleichen Vorteile auf wie der Näherungsschalter und können in entsprechender Weise weitergebildet werden; ebenso gelten umgekehrt die Vorteile der Verfahren jeweils auch für den Näherungsschalter und der Näherungsschalter kann in der gleichen Weise weitergebildet werden wie die Verfahren zu seiner Herstellung beziehungsweise seinem Betrieb.

Weitere Einzelheiten und Vorteile der Erfindung sollen nun anhand eines in den Zeichnungen dargestellten Ausführungsbeispiels näher erläutert werden.

Es zeigen:
- Fig. 1, 1A: eine Draufsicht auf eine Platine mit den Spulen eines Ausführungsbeispiels des Näherungssensors;
- Fig. 2: eine Querschnittsansicht der Platine des Ausführungsbeispiels des Näherungssensors;
- Fig. 3: eine Darstellung der Platine mit der Verstärkerschaltung des Ausführungsbeispiels des Näherungssensors;
- Fig. 4: eine Ansicht des nicht-bündigen Einbaus des Ausführungsbeispiels des Näherungssensors;
- Fig. 5: eine Ansicht des bündigen Einbaus des Ausführungsbeispiels des Näherungssensors;
- Fig. 6: ein Ausführungsbeispiel des Verfahrens zum Herstellen des Näherungssensors; und
- Fig. 7: ein Ausführungsbeispiel des Verfahrens zum Betreiben des Näherungssensors.

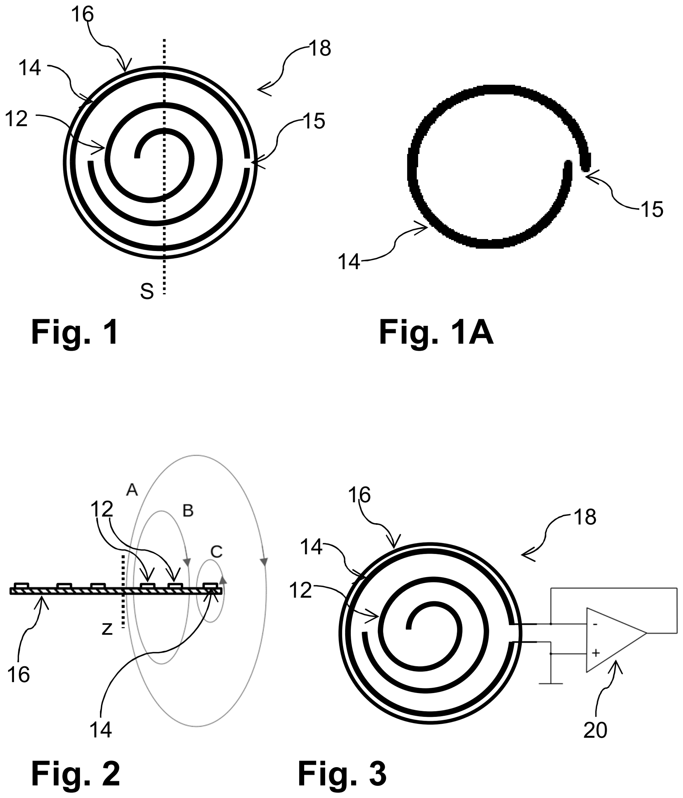

Mit Bezug zu den Figuren 1 bis 3 wird ein Ausführungsbeispiel des Näherungssensors erläutert.

In Fig. 1 ist schematisch eine Draufsicht auf einen Spulenabschnitt 18 des Näherungssensors 10 dargestellt. Mit einer gestrichelten Linie ist eine Schnittachse S angedeutet; in Fig. 2 ist ein Querschnitt entlang der Schnittachse S dargestellt. Fig. 3 zeigt schematisch die Verschaltung des Spulenabschnitts 18 mit einer Verstärkerschaltung 20.

Der Näherungssensor 10 weist eine Platine 16 auf, die bei dem Beispiel kreisrund geformt ist.

Die Platine 16 kann bei weiteren Ausführungsbeispielen anders geformt sein, beispielsweise oval, rechteckig oder quadratisch.

Die Platine 16 weist zwei gedruckte Planarspulen auf, nämlich eine Sendespule 12 und eine Ausgleichsspule 14.

Bei dem Beispiel sind die Sendespule 12 und die Ausgleichsspule 14 in der gleichen Ebene ("Kupferlage") der Platine 16 angeordnet.

Bei weiteren Ausführungsbeispielen können die Sendespule 12 und die Ausgleichsspule 14 in verschiedenen Lagen einer Platine 16 angeordnet sein. Die Spulen 12, 14 können etwa auf der Vorderseite bzw. Rückseite der Platine 16 angeordnet sein. Sie können ferner zumindest teilweise in verschiedenen Lagen ("Kupferlagen") einer mehrlagig aufgebauten Platine 16 angeordnet sein.

Bei einem weiteren Ausführungsbeispiel können die Sendespule 12 und die Ausgleichsspule 14 auf separaten Platinen 16 ausgebildet sein, die beispielsweise aufeinandergelegt oder parallel zueinander angeordnet werden.

In der Draufsicht der Fig. 1 wird die Anordnung der Sendespule 12 und der Ausgleichsspule 14 schematisch aus einer Perspektive auf einen Spulenabschnitt 18 des Näherungssensors 10 gezeigt.

Bei weiteren Ausführungsbeispielen kann der Näherungssensor 10 zudem eine oder mehrere Empfangsspulen (nicht dargestellt) aufweisen. Diese können in der gleichen oder einer anderen Ebene ("Kupferlage") der Platine 16 ausgebildet sein wie die Ausgleichsspule 14.

Die Sendespule 12 ist bei dem Beispiel spiralförmig ausgebildet und im Wesentlichen mittig auf der Platine 16 angeordnet. Sie weist hier zwei Windungen auf.

Bei weiteren Ausführungsbeispielen kann die Sendespule 12 auf andere Weisen ausgebildet sein. Sie kann beispielsweise eine oder mehrere Windungen aufweisen. Sie kann zudem als eine über mehrere Lagen einer mehrlagigen Platine 16 verlaufende Zylinderspule ausgebildet sein.

Die Ausgleichsspule 14 ist bei dem Beispiel dicht am Rand der Platine 16 angeordnet. Wie die Platine 16 ist daher auch die Ausgleichsspule 14 kreisrund.

Die Ausgleichsspule 14 weist bei dem Beispiel eine Windung auf. Sie kann bei weiteren Ausführungsbeispielen zwei, drei oder mehr Windungen aufweisen.

Die Ausgleichsspule 14 ist um die Sendespule 12 herum umlaufend ausgebildet. Sie verläuft um den gesamten Umfang der Sendespule 12 mit einer Öffnung dort, wo die Anschlüsse 15 an eine Verstärkerschaltung 20 vorgesehen sind. Bei weiteren Ausführungsbeispielen kann die Ausgleichsspule 14 so ausgebildet sein, dass sie die Sendespule 12 - bezogen auf den Umfang - vollständig oder zu wenigstens 90 % umschließt.

Beispielsweise können die Anschlüsse 15, wie in Fig. 1A gezeigt, so angeordnet sein, dass die Ausgleichsspule 14 um den gesamten Umfang der Sendespule 12 herum verläuft, etwa mit einem Überlappungsbereich.

Die Ausgleichsspule 14 ist von der Sendespule 12 getrennt ausgebildet. Insbesondere sind die Ausgleichsspule 14 und die Sendespule 12 nicht direkt miteinander gekoppelt, insbesondere gibt es keine leitende Verbindung direkt zwischen der Ausgleichsspule 14 und der Sendespule 12. Aus der Anordnung der Ausgleichsspule 14 und der Sendespule 12 ergibt sich, dass sie transformatorisch miteinander gekoppelt sind, sodass durch das elektromagnetische Feld der Sendespule 12 eine Spannung in der Ausgleichsspule 14 induzierbar ist.

Bei dem in Fig. 2 gezeigten Fall einer Querschnittszeichnung entlang der Schnittachse S sind beispielhaft einige Feldlinien A, B, C gezeigt.

Die Feldlinien A und B sind dabei den magnetischen Feldern zugeordnet, die um die von Strom durchflossenen Windungen der Sendespule 12 entstehen.

Einige Feldlinien B um die Windungen der Sendespule 12 sind innerhalb eines Bereichs geschlossen, welcher von der Ausgleichsspule 14 umgeben ist. Es gilt die 3. Maxwell-Gleichung (Induktionsgesetz): ${∮}_{\partial A} \vec{E} ⋅ d \vec{s} = - {∬}_{A} \frac{\partial \vec{B}}{\partial t} ⋅ d \vec{A}$

Demnach erzeugen diese geschlossenen Feldlinien B keine Induktionsspannung in der Ausgleichsspule 14, da sie nicht um diese herum verlaufen.

Weitere Feldlinien A verlaufen um die Ausgleichsspule 14 herum, das heißt, sie sind mit dieser verkettet.

Wenn sich das durch diese Feldlinien A dargestellte Magnetfeld verändert, wird daher eine Induktionsspannung in der Ausgleichsspannung 14 erzeugt.

Die Feldlinien A entsprechen daher einem seitlichen Streufeld, das heißt dem Anteil des gesamten Feldes, der sich in einem seitlichen Bereich ausbreitet. Wenn seitlich neben der Platine 16 ein metallisches Material angeordnet ist, dann können durch dieses Streufeld beispielsweise Wirbelströme induziert werden und es kommt zu Störungen, welche die Funktion des Näherungssensors 10 beeinträchtigen können.

Somit ist die in der Ausgleichsspule 14 induzierte Spannung ein Maß für das von der Sendespule 12 erzeugte seitliche Streufeld.

In Fig. 3 ist schematisch gezeigt, dass die Ausgleichsspule 14 an eine elektronische Verstärkerschaltung 20 angeschossen ist.

Die Verstärkerschaltung 20 ist auf an sich bekannte Weise ausgebildet und umfasst bei dem Beispiel einen invertierenden Differenzverstärker.

Bei einem Eingang der Verstärkerschaltung 20 wird die in der Ausgleichsspule 14 induzierte Spannung abgegriffen.

An einem Ausgang der Verstärkerschaltung 20 wird eine invertierte Differenzspannung zwischen den Eingängen ausgegeben. Die Verstärkerschaltung weist bei dem Beispiel einen Verstärkungsfaktor von -1 auf. Diese Ausgangsspannung wird der Ausgleichsspule 14 zugeführt.

Es fließt ein Strom vom Ausgang der Verstärkerschaltung 20 durch die Ausgleichsspule 14 und es kommt zu einem Magnetfeld, das durch die Feldlinien C dargestellt ist.

Durch die Invertierung wird erreicht, dass das durch den Strom aus der Verstärkerschaltung 20 in der Ausgleichsspule 14 erzeugte Magnetfeld C dem Streufeld A entgegengesetzt ist. Es kommt zu einer destruktiven Interferenz, durch die seitliche Streufelder der Sendespule 12 zumindest teilweise kompensiert werden.

Die Rückkopplung vom Ausgang der Verstärkerschaltung 20 zu ihrem invertierenden Eingang führt dazu, dass ein geschlossener Regelkreis aufgebaut wird. Die Verstärkerschaltung 20 regelt den Strom so, dass ihren Eingängen eine Differenzspannung von 0 V erhalten wird, was einer durch das Feld A erzeugten Induktionsspannung in der Ausgleichsspule 14 von ebenfalls 0 V entspricht.

Das heißt, das seitliche Streufeld A wird kompensiert.

Nach demselben Prinzip können auch Streufelder bei einem Näherungssensor 10 nach dem "Uprox"-Prinzip kompensiert werden. Dabei sind zusätzlich zur Sendespule 12 eine oder mehrere Empfangsspulen vorgesehen.

Die Ausgleichsspule 14 mit der Verstärkerschaltung 20 kann prinzipiell bei allen Näherungssensoren 10 eingesetzt werden. Insbesondere wird die Ausgleichsspule 14 dazu außen auf derselben Platine angeordnet wie die Sendespule 12 und gegebenenfalls vorhandene Empfangsspulen. Die Verstärkerschaltung 20 kann zweckmäßig auf einer anderen Platine untergebracht werden.

Bei dem Näherungssensor 10 erfolgt also eine selbsttätige Anpassung des Näherungssensors an die magnetischen Gegebenheiten der nahen Umgebung.

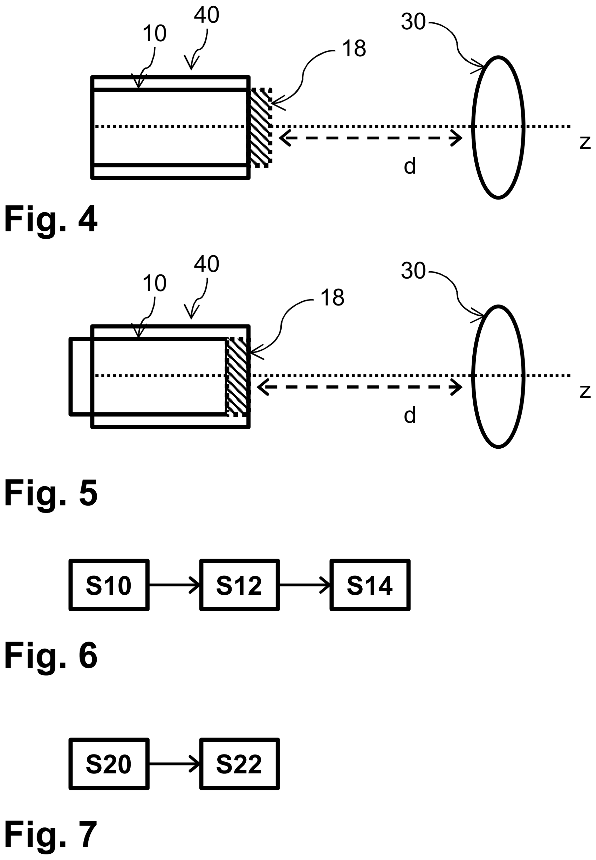

Mit Bezug zu Fig. 4 wird eine Ansicht des nicht-bündigen Einbaus des Ausführungsbeispiels des Näherungssensors erläutert. Im Kontrast dazu wird ferner mit Bezug zu Fig. 5 eine Ansicht des bündigen Einbaus des Ausführungsbeispiels des Näherungssensors erläutert. Dabei wird von dem oben beschrieben Ausführungsbeispiel eines Näherungssensors 10 ausgegangen.

Bei dem in Fig. 4 gezeigten Fall ist der Näherungssensor 10 so in eine Halterung 40 aus metallischem Material eingesetzt, dass ein Spulenabschnitt 18 des Näherungssensors 10 aus der Halterung 40 herausragt. Das heißt, der Spulenabschnitt 18 ist hier nicht von metallischem Material umgeben.

Eine gepunktete Linie deutet eine Achse z an, entlang derer eine Längsachse des Näherungssensors 10 ausgerichtet ist und entlang derer auch ein Zielobjekt 1300 detektiert werden kann. Dabei wird das Zielobjekt 30, das bei dem Beispiel als Schaltblech 30 ausgebildet ist, durch den Näherungssensor 10 erkannt, wenn sein Abstand vom Näherungssensor 10 einen Schaltabstand d unterschreitet.

Bei dem in Fig. 5 gezeigten Fall ist der Näherungssensor 10 so in der metallischen Halterung 40 eingebaut, dass er bündig mit der Halterung 40 abschließt. Das heißt, der Spulenabschnitt 18 des Näherungsschalter 10 ist ringsum von Metall umgeben. Dies kann zu Störungen führen. Bei dem vorliegend beschriebenen Näherungsschalter 10 werden diese Störungen dadurch vermieden, dass die seitlichen Streufelder der Sendespule des Näherungssensors 10 durch die Ausgleichsspule 14 verringert beziehungsweise teilweise oder ganz kompensiert werden. Dadurch kann trotz des bündigen oder gar versenkten Einbaus in einer metallischen Umgebung eine verbesserte Detektion des Zielobjekts 30 erfolgen.

Mit Bezug zu Fig. 6 wird ein Ausführungsbeispiel eines Verfahrens zum Herstellen eines Näherungssensors der oben beschriebenen Art erläutert. Dabei wird von dem oben beschrieben Ausführungsbeispiel eines Näherungssensors 10 ausgegangen.

In einem ersten Schritt S10 wird eine Sendespule 12 bereitgestellt.

In einem weiteren Schritt S12 wird eine Ausgleichsspule 14 bereitgestellt. Diese ist von der Sendespule 12 galvanisch getrennt und zumindest teilweise um die Sendespule 12 herum umlaufend ausgebildet.

In einem weiteren Schritt S14 wird die Ausgleichsspule 14 mit einer Verstärkerschaltung 20 verbunden. Dabei ist die Verstärkerschaltung 20 dazu eingerichtet ist, an einem Eingang eine in der Ausgleichsspule 14 induzierte elektrische Spannung aufzunehmen und an einem Ausgang einen Ausgleichsstrom so auszugeben, dass die induzierte elektrische Spannung kompensiert wird.

Mit Bezug zu Fig. 7 wird ein Ausführungsbeispiel eines Verfahrens zum Betreiben eines Näherungssensors der oben beschriebenen Art erläutert. Dabei wird von dem oben beschrieben Ausführungsbeispiel eines Näherungssensors 10 ausgegangen.

In einem ersten Schritt S20 wird an einem Eingang der Verstärkerschaltung 20 eine in der Ausgleichsspule 14 induzierte elektrische Spannung aufgenommen.

In einem weiteren Schritt S22 gibt die Verstärkerschaltung 20 an einem Ausgang einen Ausgleichsstrom aus, der so gebildet ist, dass die induzierte elektrische Spannung kompensiert wird.

### Bezugszeichenliste

- 10: Näherungssensor
- 12: Sendespule
- 14: Ausgleichsspule; Ausgleichswicklung
- 15: Anschlüsse
- 16: Platine
- 18: Spulenabschnitt
- 20: Verstärkerschaltung
- 30: Zielobjekt; Schaltblech
- 40: Halterung
- A: Feldlinie
- B: Feldlinie
- C: Feldlinie
- d: Schaltabstand
- S: Schnittachse
- z: Achse

## Patentansprüche

1. Näherungssensor (10) mit zumindest einer Sendespule (12) und einer Ausgleichsspule (14);
wobei die Ausgleichsspule (14) von der Sendespule getrennt ausgebildet ist und zumindest teilweise um die Sendespule (12) herum umlaufend, insbesondere im Wesentlichen vollständig um die Sendespule (12) herum umlaufend, ausgebildet ist; und
wobei die Ausgleichsspule (14) mit einer Verstärkerschaltung (20) verbunden ist;
wobei die Verstärkerschaltung (20) dazu eingerichtet ist, an einem Eingang eine in der Ausgleichsspule (14) induzierte elektrische Spannung aufzunehmen und an einem Ausgang einen Ausgleichsstrom so auszugeben, dass die induzierte elektrische Spannung kompensiert wird.

2. Näherungssensor (10) gemäß Anspruch 1,
**dadurch gekennzeichnet, dass**
der Näherungssensor (10) ferner zumindest eine Empfangsspule aufweist.

3. Näherungssensor (10) gemäß einem der vorhergehenden Ansprüche,
**dadurch gekennzeichnet, dass**
die Sendespule (12) und/oder die Ausgleichsspule (14) als gedruckte Spulen ausgebildet sind, insbesondere als Planarspulen.

4. Näherungssensor (10) gemäß einem der vorhergehenden Ansprüche,
**dadurch gekennzeichnet, dass**
die Sendespule (12) und die Ausgleichsspule (14) auf einer gemeinsamen Platine (16) angeordnet sind.

5. Näherungssensor (10) gemäß Anspruch 4,
**dadurch gekennzeichnet, dass**
die Sendespule (12) mehrlagig in mehreren Schichten der Platine (16) ausgebildet ist, wobei zumindest eine Wicklung der Ausgleichsspule (14) in zumindest einer gemeinsamen Schicht mit der Sendespule 12() angeordnet ist.

6. Näherungssensor (10) gemäß einem der vorhergehenden Ansprüche, **dadurch gekennzeichnet, dass**
die Verstärkerschaltung (20) einen invertierenden Verstärker, insbesondere einen Differenzverstärker oder Operationsverstärker, umfasst.

7. Näherungssensor (10) gemäß einem der vorhergehenden Ansprüche, **dadurch gekennzeichnet, dass**
die Verstärkerschaltung (20) einen Verstärkungsfaktor in einem Intervall zwischen -0,9 und -1,5 aufweist, bevorzugt zwischen -1,0 und -1,3, weiter bevorzugt von -1.

8. Näherungssensor (10) gemäß einem der vorhergehenden Ansprüche, **dadurch gekennzeichnet, dass**
die Sendespule (12) und die Ausgleichsspule (14) konzentrisch ausgebildet sind.

9. Verfahren zum Herstellen eines Näherungssensors (10); umfassend
Bereitstellen zumindest einer Sendespule (12);
Bereitstellen einer von der Sendespule (12) getrennt ausgebildeten und zumindest teilweise, insbesondere im Wesentlichen vollständig, um die Sendespule (12) herum umlaufenden Ausgleichsspule (14) so, dass die Ausgleichsspule (14) mit einer Verstärkerschaltung (20) verbunden ist;
wobei die Verstärkerschaltung (20) dazu eingerichtet ist, an einem Eingang eine in der Ausgleichsspule (14) induzierte elektrische Spannung aufzunehmen und an einem Ausgang einen Ausgleichsstrom so auszugeben, dass die induzierte elektrische Spannung kompensiert wird.

10. Verfahren zum Betreiben eines Näherungssensors (10);
wobei der Näherungssensor (10) eine Sendespule (12) und eine von der Sendespule (12) getrennt ausgebildete und zumindest teilweise, insbesondere im Wesentlichen vollständig, um die Sendespule (12) herum umlaufende Ausgleichsspule (14) aufweist, wobei die Ausgleichsspule (14) mit einer Verstärkerschaltung (20) verbunden ist; wobei das Verfahren umfasst:
Aufnehmen einer in der Ausgleichsspule (14) durch ein elektromagnetisches Feld, insbesondere ein Streufeld der Sendespule, induzierten elektrischen Spannung an einem Eingang der Verstärkerschaltung (20); und
Ausgeben eines Ausgleichsstroms an einem Ausgang der Verstärkerschaltung (20) so, dass das elektromagnetische Feld, insbesondere das Streufeld der Sendespule, die induzierte elektrische Spannung kompensiert wird.
